**Europäisches Patentamt**

**European Patent Office**

**Office européen des brevets**

(19)

(11) Veröffentlichungsnummer: **0 030 233**
**B1**

(12)

# EUROPÄISCHE PATENTSCHRIFT

(45) Veröffentlichungstag der Patentschrift:
13.04.83

(51) Int. Cl.³: **B 23 K 1/00**

(21) Anmeldenummer: **80900763.6**

(22) Anmeldetag: **08.05.80**

(86) Internationale Anmeldenummer:
**PCT/CH 80/00054**

(87) Internationale Veröffentlichungsnummer:
**WO 80/02662 (11.12.80** Gazette 80/28)

(54) **ANORDNUNG ZUM KONTAKTIEREN DER LEITERBAHNEN VON LEITERPLATTEN MIT KONTAKTSTIFTEN.**

(30) Priorität: **05.06.79 CH 5195/79**

(43) Veröffentlichungstag der Anmeldung:
**17.06.81 Patentblatt 81/24**

(45) Bekanntmachung des Hinweises auf die Patenterteilung:
**13.04.83 Patentblatt 83/15**

(84) Benannte Vertragsstaaten:
**DE FR GB NL SE**

(56) Entgegenhaltungen:
**DE-A-2 257 003**
**IBM Technical Disclosure Bulletin, volume 11,**
**no. 6, publiziert November 1968, (Armonk, New**
**York, US), L.A. Willard »Induction Stacking«,**
**Seite 679**

(73) Patentinhaber: **SIEMENS-ALBIS**
**AKTIENGESELLSCHAFT, EGA1/Verträge und Patente**
**Postfach, CH-8047 Zürich (CH)**

(72) Erfinder: **FORSTNER, Anton, Gassackerstrasse 19,**
**CH-8953 Dietikon (CH)**
Erfinder: **BAJKA, Imre, Bachenbülacher 8,**
**CH-8172 Niederglatt (CH)**

(74) Vertreter: **Nideröst, Werner et al, Siemens-Albis AG**
**EGA 1 Verträge und Patente Albisriederstrasse 245,**
**CH-8047 Zürich (CH)**

## Anordnung zum Kontaktieren der Leiterbahnen von Leiterplatten mit Kontaktstiften

Die vorliegende Erfindung betrifft eine Anordnung zum Kontaktieren der Leiterbahnen von Leiterplatten mit Kontaktstiften, die in Bohrungen der Leiterplatte eingesetzt sind und die mittels in der Nähe der zu kontaktierenden Stellen angebrachter Körper aus Lötmaterial durch Zuführung von Wärme elektrisch leitend mit den Leiterbahnen verbunden werden.

In Geräten der Nachrichten- und Datenverarbeitungstechnik werden heute sogenannte Rückwandleiterplatten verwendet. Diese ein- oder auch mehrlagigen Platten stellen gedruckte Schaltungen dar, die als Rückwand in Gestellen eingesetzt sind und auf denen zwischen den im Gestell untergebrachten, mit Bauelementen bestückten Baugruppen bestehende Verbindungen in Form von Leiterbahnen aufgebracht sind. Ferner werden diese Platten zur Vermaschung der Versorgungsspannungen und des Bezugspotentials eingesetzt. Eine Rückwandleiterplatte weist eine Vielzahl von Steckleisten auf, deren in Reihen angeordnete Kontaktstifte durch Löcher in der Rückwandleiterplatte hindurchragen und elektrisch leitend mit den Leiterbahnen verbunden sind. Die Baugruppen werden durch Aufstecken auf diese Steckerleisten in das Gestell eingesetzt. Die aus der Rückwandleiterplatte auf der Rückseite des Gestelles herausragenden Kontaktstifte ermöglichen in einfacher Weise die Herstellung zusätzlicher Verbindungen zwischen bestimmten Schaltungspunkten beispielsweise nach bekannten lötfreien Verfahren, wie Wickel-, Crimp- oder Klammer-Verbindungen.

Es besteht nun das Problem, die vielen Kontaktstifte dieser Steckerleisten in möglichst rationeller Weise zuverlässig mit den Steckerpunkten auf der Rückwandleiterplatte zu kontaktieren, d. h. eine einwandfreie elektrische Verbindung zwischen dem Kontaktstift und dem leitenden Material auf der gedruckten Schaltungsplatte zu schaffen. Eine Einzellötung nach konventionellen Methoden fällt hier außer Betracht, da einerseits bei der Vielzahl von zu kontaktierenden Punkten eine rationelle Arbeitsweise nicht mehr möglich ist und andererseits die mit der ständig fortschreitenden Miniaturisierung immer kleiner werdenden Abstände zwischen den einzelnen Kontaktstiften eine zuverlässige Kontaktierung in Frage stellen. Ebenso ist eine Kontaktierung mittels Lötbad nicht möglich, da dabei in unerwünschter Weise die Kontaktstifte selbst mit dem Lot überzogen würden. Zur Umgehung dieser Schwierigkeiten wird in der DE-A-2 257 003 eine Vorrichtung zum Kontaktieren von auf einer Leiterplatte verlaufenden Leiterbahnen mit Kontaktelementen vorgeschlagen, die eine Strahlungsquelle, wie z. B. eine Halogenlampe aufweist, deren Strahlungswärme den mit einem Lötmittel versehenen Kontaktstellen zugeführt wird. Die Bündelung und Zuführung der Wärmestrahlung zu den Kontaktstellen erfolgt mit Fokussiermitteln, wobei zusätzlich eine Transporteinrichtung vorgesehen ist, die die zu kontaktierenden Stellen auf der Leiterplatte aufeinanderfolgend für eine bestimmte Zeitspanne in den Wirkungsbereich der Strahlungsquelle bringt. Mit dieser Vorrichtung kann also nur eine Kontaktstelle gleichzeitig gelötet werden, was bei einer großen Zahl von Kontaktstellen einen erheblichen Zeitaufwand erfordert. Ein weiterer ungünstiger Umstand ist bei dieser Vorrichtung darin zu sehen, daß insbesondere bei kleinen Abständen der Kontaktstellen nicht nur eine Erwärmung der gewünschten Kontaktstelle selbst, sondern auch eine Erwärmung in deren unmittelbaren Umgebung eintreten dürfte und damit allenfalls dort verlaufende Leiterbahnen wie auch das Trägermaterial der Leiterplatte in Mitleidenschaft gezogen werden können.

In »IBM Technical Disclosure Bulletin«, Vol. 11, Nr. 6/Nov. 1968 ist auf Seite 679 unter dem Titel »Induction stacking« eine Vorrichtung zum Verlöten von Anschlußstiften mit dem Substrat von integrierten Schaltungen kurz angegeben, bei der die zum Schmelzen des Lotes notwendige Wärme mittels einer Induktionsschlaufe zugeführt wird. Das Problem einer gleichmäßigen Erwärmung der Lötstellen beim Verlöten einer großen Zahl von Steckerstiften auf großflächigen Leiterplatten ist in dieser Veröffentlichung nicht angesprochen.

Der vorliegenden Erfindung liegt die Aufgabe zugrunde, eine Anordnung der eingangs genannten Art zu schaffen, die in einfacher Weise ein rationelles Löten einer Vielzahl von in Reihen angeordneten Kontaktstellen auf Leiterplatten ermöglicht und bei der eine gezielte Wärmeeinwirkung auf diese Kontaktstellen erreicht wird. Dies gelingt erfindungsgemäß mit einer Anordnung, wie sie in den Ansprüchen gekennzeichnet ist.

Die Anordnung gestattet in vorteilhafter Weise, die Anschlußstifte von eng beieinanderliegenden Steckerleisten reihenweise zuverlässig und rasch mit den vorgesehenen Kontaktstellen einer Leiterplatte zu verlöten. Durch zweckmäßige Ausbildung der Induktionsschlaufe wird überdies eine gleichmäßige Energieverteilung für alle Kontaktstellen erreicht und damit allen in einen Lötvorgang einbezogenen Kontaktstellen die gleiche Wärmeenergie gleichzeitig zugeführt. Damit ergibt sich eine geringere Lötzeit, wodurch auch die Gefahr einer Überhitzung einzelner Kontaktstellen und deren unmittelbaren Umgebung herabgesetzt wird. Weiterbildungen der Erfindung und sich daraus ergebende Vorteile sind aus der nachfolgenden Beschreibung eines Ausführungsbeispieles anhand einer Zeichnung ersichtlich. Dabei zeigt

Fig. 1 eine prinzipielle Darstellung der Anordnung,

Fig. 2 Einzelheiten der Induktionsschlaufe,

Fig. 3 eine Weiterbildung,

Fig. 4 einen speziellen Anwendungsfall der Anordnung.

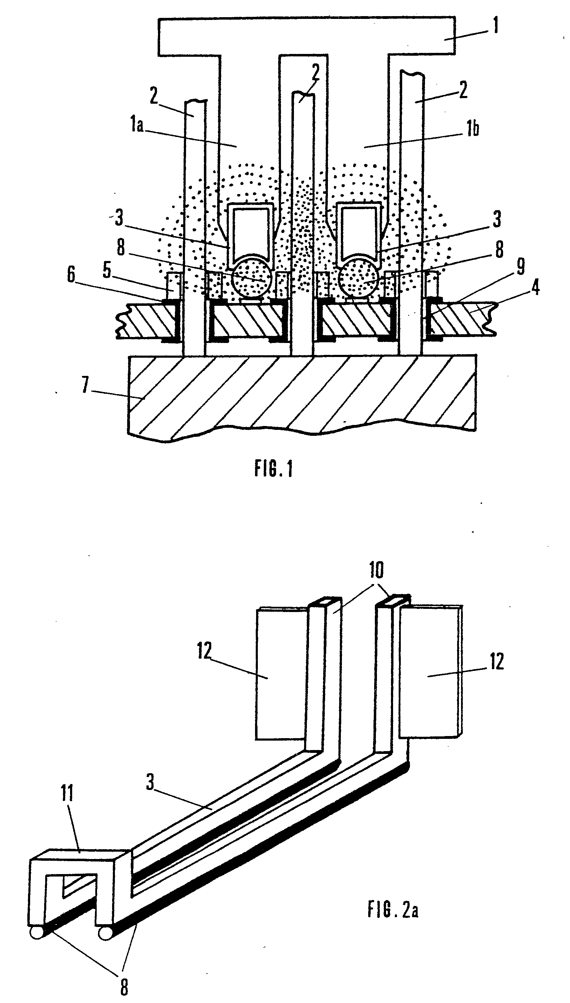

In Fig. 1 ist in einem Schnittbild eine Leiterplatte 4 mit Löchern als Durchführungen 9 dargestellt, durch die auf einem Isolierkörper 7 einer Steckerleiste angeordnete Kontaktstifte 2 hindurchragen. Die Steckerleiste weist mehrere zueinander parallele Reihen von Kontaktstiften 2 auf. Die Durchführungen 9 sind zweckmäßigerweise durchkontaktiert, d. h. durchgehend mit einem leitenden Material belegt, das elektrisch leitend mit entsprechenden Leiterbahnen auf der Leiterplatte verbunden ist. Zur Herstellung einer elektrischen Verbindung zwischen den Kontaktstiften 2 und den Durchführungen 9 sind über die Stifte 2 gestülpte Lötringe 5 vorhanden. Die Anordnung zum Kontaktieren weist im wesentlichen einen Träger 1 mit zwei zueinander parallel verlaufenden Schenkeln 1a, 1b auf, an denen Teilstücke einer im vorliegenden Fall annähernd rechteckförmigen Induktionsschlaufe 3 angebracht sind. Die Schlaufe besteht aus einem Kupferrohr mit rechteckförmigem Querschnitt, das von einer Kühlflüssigkeit, z. B. Wasser, durchflossen wird. Die Induktionsschlaufe 3 ist mit einem Hochfrequenzgenerator verbunden und erzeugt somit ein elektromagnetisches Wechselfeld, dessen Verlauf in Fig. 1 punktiert angegeben ist. Durch nicht weiter dargestellte Mittel ist eine Verschiebung des Trägers 1 gegenüber der Leiterplatte 4 oder umgekehrt ermöglicht. Insbesondere läßt sich der Träger 1 in die in Fig. 1 gezeigte Lage auf die Leiterplatte 4 absenken. In dieser Lage wird die mittlere Reihe von Kontaktstiften 2 von den beiden schenkeln 1a und 1b umschlossen. Dabei gelangen die Kontaktstifte 2, die Lötringe 5 und die Lötaugen 6 der Kontaktstellen in den Einflußbereich des magnetischen Wechselfeldes, was deren Erwärmung durch in bekannter Weise auftretende Wirbelströme zur Folge hat. Die in den Kontaktstiften 2 erzeugte Wärmeenergie wird zudem an die Lötringe 5 übertragen. Dadurch werden diese zum Schmelzen gebracht und es erfolgt somit eine Kontaktierung der betreffenden Kontaktstifte 2 mit den Leiterbahnen auf der Leiterplatte 4. Die in dieser Weise herbeigeführte Wärmeübertragung von den Kontaktstiften 2 auf die Lötringe 5 bewirkt in vorteilhafter Weise, daß nur diejenigen Elemente der Kontaktstelle erwärmt werden, die tatsächlich erwärmt werden müssen. Das die Kontaktstellen umgebende nichtleitende Leiterplattenmaterial wird dabei — abgesehen von der vernachlässigbaren Strahlungswärme — nicht beeinflußt. Mit dieser Anordnung kann eine Vielzahl von Kontaktstiften 2 gleichzeitig gelötet werden. Daraus ergibt sich eine rationelle Arbeitsweise, die mit Hilfe einer vollautomatischen Lagesteuerung des Trägers 1 bzw. der Leiterplatte 4 noch optimiert werden kann. Die erfindungsgemäße Anordnung läßt sich ohne weiteres auch zur Kontaktierung von Kontaktstellen anwenden, deren Bohrungen nicht durchkontaktiert sind.

In Fig. 2a sind weitere Einzelheiten der Induktionsschlaufe 3 gezeigt. Diese Induktionsschlaufe 3 ist insbesondere zum gleichzeitigen Kontaktieren einer oder mehrerer Reihen von Kontaktstiften 2 ausgelegt. Auf der Anschlußseite mit den Zuleitungen 10 sind über nicht weiter dargestellte Mittel sowohl der erwähnte Hochfrequenzgenerator als auch ein Kühlwassersystem angeschlossen. Das der Anschlußseite gegenüberliegende Schlaufenende enthält einen u-förmigen Steg 11, der bezüglich der zu verlötenden Kontaktstellen eine hochgesetzte Verbindung zwischen den beiden parallelen Längsteilen der Induktionsschlaufe 3 bildet. Diese Art der Ausbildung des Schlaufendes hat folgenden Grund: Wenn das Schlaufenende ohne hochgesetzten Steg 11 ausgeführt ist, d. h. wenn der Verbindungsteil am Schlaufenende in der gleichen Ebene liegt wie die beiden Längsteile, dann weist das im Bereich des Schlaufenendes entstehende Magnetfeld eine größere Feldliniendichte auf als dasjenige in der übrigen Schlaufe. Die sich daraus am Schlaufenende ergebende erhöhte Energiekonzentration gefährdet die sich während dem Lötvorgang in diesem Bereich befindlichen Kontaktstifte, indem diese auf unzulässige Temperaturen erwärmt werden und dabei durch Verglühen zerstört werden können. Mit dem hochgesetzten Steg 11 am Schlaufenende kann die unerwünschte Energiekonzentration auf einen zulässigen Wert reduziert werden, wobei das Maß für die Erhöhung des Steges 11 gegenüber den Längsteilen der Schlaufe 3 entsprechend den von Fall zu Fall vorliegenden Gegebenheiten zu wählen ist.

Die Zuleitungen 10 auf der Anschlußseite der Induktionsschlaufe 3 stehen im Interesse einer möglichst kompakten Anordnung wenigstens annähernd senkrecht auf den Längsteilen. Es entsteht auch auf dieser Seite der Schlaufe 3 ein Bereich mit erhöhter Energiekonzentration, die während dem Lötvorgang sich in diesem Bereich befindliche Kontaktstifte 2 gefährden kann. Dieser Gefahr kann dadurch begegnet werden, daß an den Zuleitungen 10 Flügel 12, z. B. aus Kupfer, angebracht werden, die senkrecht zur Richtung der die Zuleitungen 10 umschließenden magnetischen Feldlinien stehen. Damit wird eine Verringerung der Induktivität der Zuleitungen 10 und eine Reduktion der Energiekonzentration in diesem Bereich erzielt. Gleichzeitig ergibt sich eine Erhöhung der Energiekonzentration im Bereich der Längsteile der Induktionsschlaufe 3.

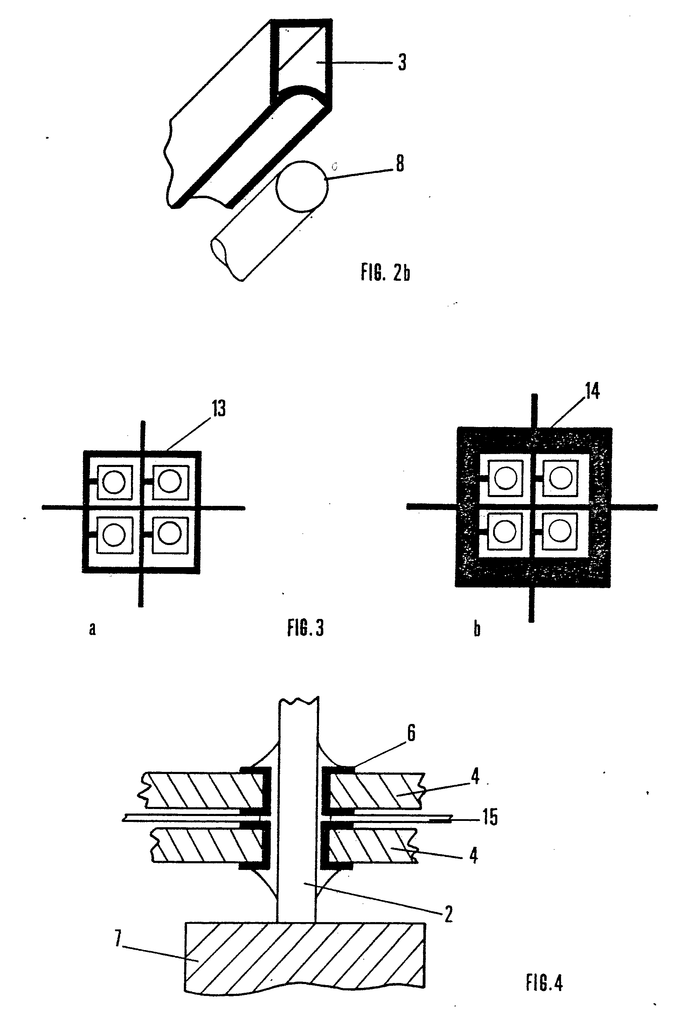

Es besteht weiter die Gefahr, daß das durch die Induktionsschlaufe 3 erzeugte magnetische Wechselfeld in unerwünschter Weise auch Wirbelströme in Leiterbahnabschnitten auf der Leiterplatte 4 hervorrufen kann, die eine unzulässige Erwärmung mit anschließender Zerstörung dieser Leiter zur Folge haben. Dabei sind vor allem unmittelbar in der Nähe von zu kontaktierenden Stiften 2 verlaufende Leiterbahnen auf der Induktionsschlaufe 3 zugewandten Leiterplattenseite gefährdet. Solche Leiterbahnen sind insbesondere auf gedruckten Schaltungsplatten in bekannter Weise netzartig angeordnete Erd- und Speiseleitungen 13 (Fig. 3a). Um diese Gefahr zu eliminieren, ist die der Leiterplatte 4 zugewandte Seite der Längsteile der Induktionsschlaufe 3 mit einem Ferritmaterial 8 belegt. Dadurch kann der Verlauf der magnetischen Feldlinien derart verändert werden, daß deren Einfluß auf die genannten Leiterbahnen wirksam herabgesetzt oder gar aufgehoben wird. Die Änderung des Feldlinienverlaufs ist in Fig. 1 punktiert angedeutet. In Fig. 2b ist eine Möglichkeit für das Anbringen des Ferritmaterials 8 gezeigt. Dabei wird das vorzugsweise stabförmige Ferritmaterial 8 in eine Wölbung der Induktionsschlaufe 3 eingesetzt, wobei die Tiefe der Wölbung einerseits und der Durchmesser des Ferritmaterials 8 andererseits den kürzestmöglichen Abstand der Induktionsschlaufe 3 von der Leiterplatte 4 bestimmen.

In Anwendungsfällen, wo die erwähnte erhöhte Energiekonzentration im Bereich des Schlaufenendes keine Gefährdung umliegender Elemente bewirkt, kann auf den Steg 11 verzichtet werden, was nicht zuletzt eine vereinfachte Herstellung der Induktionsschlaufe 3 ermöglicht. In solchen Fällen wird die Verbindung zwischen den beiden Längsteilen auf gleicher Höhe wie diese angebracht. Unter Umständen kann es dann genügen, auch diese Verbindung mit dem Ferritmaterial 8 zu belegen, um die erforderliche Schutzwirkung zu erzielen. Im übrigen ist noch darauf hinzuweisen, daß das Ferritmaterial 8 nicht in jedem Fall auf der der Leiterplatte 4 zugewandten Unterseite der Induktionsschlaufe 3 angebracht werden muß. Es ist durchaus denkbar, je nach den in einem bestimmten Anwendungsfall vorliegenden Gegebenenheiten das Ferritmaterial 8 auch auf der Oberseite oder Seitlich an der Induktionsschlaufe 3 anzubringen und so die gewünschte Schutzwirkung zu erreichen.

In vielen Fällen läßt sich trotz der bisher beschriebenen Maßnahmen infolge sehr enger Platzverhältnisse nicht vermeiden, daß Leiterbahnen in den Einflußbereich des durch die Induktionsschlaufe 3 erzeugten Magnetfeldes gelangen und bei übermäßiger Erwärmung zerstört werden. Die in Fig. 3a gezeigten Erdrasterleiterbahnen 13, die in der Regel relativ schmal (≤0,5 mm) sind, können auf der Lötseite und/oder auf der Bestückungsseite, d. h. auf der der Induktionsschlaufe 3 abgewandten Seite der Leiterplatte 4 angeordnet sein. Um solche Leiterbahnen zusätzlich vor einer unzulässigen Erwärmung zu schützen, ist es zweckmäßig, insbesondere auf der Lötseite an geeigneter Stelle eine möglichst breite aus Leitermaterial bestehende Umrandung 14 (Fig. 3b) anzubringen. Diese Umrandung 14 schützt die dünnen Leiterbahnen sowohl auf der Löt- als auch auf der Bestückungsseite, indem sie einen Teil der unerwünschten Wärmeenergie abführt.

Zur Erzielung einer für alle in einem Lötvorgang zu erfassenden Stifte 2 möglichst gleichen Wärmezufuhr muß die Parallelität der beiden langen Teilstücke der Induktionsschlaufe 3 in engen Toleranzen (±0,05 mm) eingehalten werden. Nur so kann eine einwandfreie Qualität aller Lötstellen erzielt werden. Werden diese Toleranzen nicht eingehalten, dann wird das aufgebaute Energiefeld ungleichmäßig, was eine Verlängerung der Lötzeit, überhitzte Lötstellen und damit Lötstellen unterschiedlicher Qualität zur Folge hat. Zwecks Isolation kann die Unduktionsschlaufe 3 mit einem geeigneten Isoliermaterial überzogen werden, daß überdies wärmebeständig ist. Dieses als Folie aufgebrachte Material bringt zudem den Vorteil mit sich, daß allenfalls an der Schlaufe zurückbleibende Flußmittelrest durch Reinigen der Folie einfach und rasch entfernt werden können.

Die beschriebene Lötanordnung läßt sich in vorteilhafter Weise auch bei mehrlagigen Leiterplatten (Multilayer) und bei Anordnungen von mehreren Leiterplatten, die durch die Kontaktstufte von Steckerleisten miteinander verbunden sind (Multipack), anwenden. Das Prinzip einer Multipack-Leiterplatte ist in Fig. 4 gezeigt. Zwischen die Leiterplatten 4 ist eine Isolationsschicht 15 eingefügt. Durch entsprechende Wahl der Lötzeit ist es mit der anhand von Fig. 1 beschriebenen Anordnung möglich, zwei und mehr übereinanderliegende, durch eine Isolationsschicht voneinander getrennte Leiterplatten 4 in einem Lötvorgang miteinander zu verlöten. Dabei gelingt infolge der gleichmäßigen Erwärmung der Kontaktstiftreihen die Erzeugung von Lötstellen mit auf beiden Seiten einwandfrei ausgebildeten Lotkegeln, indem das Lot der auf der Lötseite über die Kontaktstifte 2 gestülpten Lötringe durch die Durchführungen der Leiterplatten 4 hindurchläuft. Es ist also im Gegensatz zu der eingangs erwähnten bekannten Vorrichtung nicht erforderlich, die Leiterplatten 4 nacheinander mit den Kontaktstiften 2 zu verlöten, was einen geringeren Arbeitsaufwand bedeutet.

Anstelle des bei der Beschreibung der Fig. 1 und 2 beispielsweise erwähnten Ferritmaterials 8 können selbstverständlich auch andere Materialien mit entsprechenden elektromagnetischen Eigenschaften vorgesehen werden, und zwar vorzugsweise solche Materialien, die in einfacher Weise, wie z. B. durch Gießen, jede beliebige gewünschte Formgebung zulassen.

**Patentansprüche**

1. Anordnung zum Kontaktieren der Leiterbahnen von Leiterplatten (4) mit Kontaktstiften (2), die in Bohrungen (9) der Leiterplatte (4) eingesetzt sind und die mittels in der Nähe der zu kontaktierenden Stellen angebrachter Körper (5) aus Lötmaterial durch Zuführung von Wärme elektrisch leitend mit den Leiterbahnen verbunden werden, dadurch gekennzeichnet; daß eine verschiebbare, von einem hochfrequenten Wechselstrom durchflossene Induktionsschlaufe (3) vorgesehen ist, die beim Absenken auf die Leiterplatte (4) wenigstens eine Reihe der zu kontaktierenden Stifte (2) umfaßt und diese dabei gleichzeitig mit den zugehörigen Kontaktstellen in den Einflußbereich des magnetischen Wechselfeldes gelangen.

2. Anordnung nach Anspruch 1, dadurch gekennzeichnet, daß die Induktionsschlaufe (3) annähernd rechteckförmig ausgestaltet ist, wobei deren Längsteile an zwei zueinander parallel verlaufenden Schenkeln (1a, 1b) eines Trägers (1) angebracht sind, der bezüglich der Leiterplattenebene in horizontaler und vertikaler Richtung verschiebbar ist.

3. Anordnung nach Anspruch 2, dadurch gekennzeichnet, daß am Schlaufenende ein u-förmiger Steg (11) vorgesehen ist, der eine gegenüber der Ebene der beiden Längsteile der Induktionsschlaufe (3) erhöhte Verbindung zwischen den Längsteilen bildet.

4. Anordnung nach Anspruch 3, dadurch gekennzeichnet, daß die Induktionsschlaufe (3) auf der Anschlußseite wenigstens annähernd parallel zur Richtung der zu kontaktierenden Kontaktstifte (2) verläuft und an jeder Zuleitung (10) mindestens einen Flügel (12) aufweist, der senkrecht zur Ebene der Längsteile der Induktionsschlaufe (3) steht.

5. Anordnung nach einem der vorangehenden Ansprüche, dadurch gekennzeichnet, daß die Induktionsschlaufe (3) wenigstens teilweise mit einem Ferritmaterial (8) oder einem anderen entsprechende elektromagnetische Eigenschaften aufweisenden Material belegt ist.

6. Anordnung nach Anspruch 5, dadurch gekennzeichnet, daß auf der Leiterplatte (4) selbst wenigstens auf der der Schlaufe (3) zugewandten Seite in der Umgebung der zu kontaktierenden Stellen zusätzliches Leitermaterial aufgebracht ist.

7. Anordnung nach Anspruch 1, dadurch gekennzeichnet, daß die Induktionsschlaufe (3) mit einem wärmebeständigen Isoliermaterial überzogen ist.

## Claims

1. An arrangement for contacting the conductor paths of printed circuit boards (4) ny means of contacts pins (2) which are inserted in bores (9) in the printed circuit board (4) and which are connected in electrically conducting fashion to the conductor paths by supplying heat, by means of bodies (5) made of solder material and which are placed in the vicinity of the locations to be contacted, characterised in that a displaceable induction loop (3) is provides through which a high-frequency alternating current flows and which on lowering onto the printed circuit board (4) embraces at least one row of the pins (2) to be contacted, which pins thereby come into the zone of influence of the alternating magnetic field at the same time as the contact locations appertaining thereto.

2. An arrangement according to claim 1, characterised in that the induction loop (3) is approximately rectangular, its longitudinal parts being secured to two mutually parallel limbs (1a, 1b), of a carrier (1) which is displaceable in the horizontal und vertical directions with respect to the plane of the printed circuit board.

3. An arrangement according to claim 2, characterised in that the end of the loop is provided with a U-shapped cross-piece (11) which forms a connection between the longitudinal parts of the induction loop which is raised in relation to the plane of these longitudinal parts.

4. An arrangement according to claim 3, characterised in that on the connection side, the induction loop (3) extends at least approximately parallel to the direction of the contact pins (2) to be contacted, and is provided at each lead-in (10) with at least one wing (12), which is perpendicular to the plane of the longitudinal parts of the induction loop (3).

5. An arrangement according to one of the preceding claims, characterised in that the induction loop (3) is at least perially coated with a ferrite material (8), or with another material which exhibits corresponding elektromagnetic properties.

6. An arrangement according to claim 5, characterised in that on the printed circuit board (4) itself, at least on the side facing the loop (3), additional conductive material is applied in the region of the locations to be contacted.

7. An arrangement according to claim 1, characterised in that the induction loop (3) is coated with a heatresistant insulating material.

## Revendications

1. Dispositif pour établir des contacts entre des voies conductrices de plaquettes à circuits imprimés (4) et des broches de contact (2) qui sont insérées dans des perçages (9) de la plaquette à circuits imprimés (4) et qui sont reliées de façon électriquement conductrice aux voies conductrices, par apport de chaleur à l'aide de corps (5) formés avec un matériau de soudure et disposés à proximité des points devant être contactés, caractérisé en ce qu'il est prévu une boucle d'induction (3) déplaçable, parcourue par un courant alternatif de haute fréquence et qui, lors de son abaissement sur la plaquette à circuits imprimés (4), entoure au moins une rangée des broches (2) devant être contactées, et que ces dernières parviennent, en même temps que les points de contacts associés, dans la zone d'influence du champ magnétiques alternatif.

2. Dispositif selon la revendication 1, caractérisé en ce que la boucle d'induction (3) est réalisée avec une forme approximativement rectangulaire, ses parties longitudinales étant disposées sur deux branches (1a, 1b) parallèles entre elles d'un support (1) qui est déplaçable horizontalement et verticalement par rapport au plan de la plaquette à circuits imprimés.

3. Dispositif selon la revendication 2, caractérisé en ce qu'il est prévu sur l'extrémité de la boucle un étrier en forme de U (11) qui établit entre les parties longitudinales et la boucle d'induction (3) une liaison surélevée au-dessus du plan de ces parties.

4. Dispositif selon la revendication 3, caractérisé en ce que la boucle d'induction (3) s'étend, du côté du raccordement, au moins approximativement parallèlement aux broches de contact (2) devant être contactées et comporte, sur chaque conducteur d'alimentation (10) au moins une aile (12) qui est perpendiculaire au plan des parties longitudinales de la boucle d'induction (3).

5. Dispositif selon l'une des revendications précédentes, caractérisé en ce que la boucle d'induction (3) est recouverte au moins partiellement par un ferrite (8) ou par un autre matériau possédant des propriétés électromagnétiques correspondantes.

6. Dispositif selon la revendiaction 5, caractérisé en ce qu'un matériau conducteur supplémentaire est disposé sur la plaquette à circuit imprimés (4) elle-même, au moins sur la face tournée vers la boucle (3), dans l'entrourage des points devant être contactés.

7. Dispositif selon la revendication 1, caractérisé en ce que la boucle d'induction (3) est recouverte par un matériau isolant résistant à chaleur.

FIG. 1

FIG. 2a

FIG. 2b

a      FIG. 3      b

FIG.4